# EUROPEAN PATENT APPLICATION

(11) **EP 3 319 167 A1**
(43) Date of publication of application: **09.05.2018**
(21) Application number: 17154980.1
(22) Date of filing: 07.02.2017
(51) Int. Cl.: H01P 3/16, H05K 1/02, G02B 6/12, H01P 5/08, H01P 5/10, H01P 3/12

(54) **PRINTED-CIRCUIT BOARD HAVING ANTENNAS AND ELECTROMAGNETIC-TUNNEL-EMBEDDED ARCHITECTURE AND MANUFACTURING METHOD THEREOF**

(30) Priority: 08.11.2016 KR 20160148206
(71) Applicant: Korea Advanced Institute of Science and Technology, Daejeon 34141 (KR)
(72) Inventor: PARK, HyoHoon, 34141 Daejeon (KR); BAE, Hyeon-Min, 34141 Daejeon (KR); SONG, Ha Il, 34141 Daejeon (KR); LEE, Daeseong, 34141 Daejeon (KR); LEE, Harin, 34141 Daejeon (KR)
(74) Representative: Pronovem

(57) **Abstract**

Disclosed is a printed circuit board (PCB) structure, in which an electromagnetic signal transmitting antenna and/or an electromagnetic signal receiving antenna, and an electromagnetic signal transferring tunnel (EM-tunnel) are embedded, the PCB structure including a PCB, an EM-tunnel that includes a dielectric core and a metal clad that surrounds the dielectric core and that is embedded in the PCB to be parallel to the PCB, and at least one transmitting antenna and/or at least one receiving antenna that are embedded in the PCB, wherein the transmitting antenna and/or the receiving antenna are arranged at an input port and an output port of the EM-tunnel embedded in the PCB to transmit and receive electromagnetic signals to and from the interior of the EM-tunnel.

## Description

### CROSS-REFERENCE TO RELATED APPLICATIONS

A claim for priority under 35 U.S.C. § 119 is made to Korean Patent Application No. 10-2016-0148206 filed November 08, 2016, in the Korean Intellectual Property Office, the entire contents of which are hereby incorporated by reference.

### BACKGROUND

Embodiments of the inventive concept described herein relate to a printed circuit board (hereinafter, referred to as a PCB) in which an electromagnetic signal transmitting antenna and an electromagnetic signal receiving antenna, and an electromagnetic signal transferring tunnel (hereinafter, referred to as an EM-tunnel) are embedded, and a method of manufacturing the same, and more particularly to, a technology of a PCB, in which a transmitting antenna and a receiving antenna that transmits and receives electromagnetic signals and an EM-tunnel that transfers electromagnetic signals are embedded.

A high-performance computer or a communication system requires a substrate that is suitable for processing of high-capacity and high-speed data. Accordingly, the highly-integrated PCB technologies which use a multilayered circuit having a high density of metal lines have been developed as substrate technologies for high-capacity/high-speed data processing, but an electromagnetic interference between adjacent metallic signal lines increases and signal loss becomes severe as data transmission speed increases. In particular, most of signal losses in high-density multilayered metal lines are generated due to impedance mismatching at high frequency, and thus a new method for fundamentally solving the impedance problem is required.

As a new method to solve the impedance problem, an electromagnetic signal transmission technology of using an electromagnetic tube (hereinafter, referred to as an E-tube) as a waveguide of electromagnetic wave to transfer high-speed data between chips or boards has been proposed in Korean Patent Application No. 10-2015-0029742, U.S. Patent Application No. US 140184351, Nature Scientific Reports (vol. 5, p. 16062, 2015), and the like. The E-tube is an electromagnetic signal transferring line of a tube type prepared by coating a metal thin film on a dielectric waveguide. It can be easily bent by using a flexible dielectric material and a metal thin film, thereby functioning to connect a transmission part and a reception part while being bent through a free space, not through a PCB.

Meanwhile, as the structures for transmitting electromagnetic waves through a PCB, instead of a free space, the structures of a printed circuit, in which an electromagnetic signal transmission tunnel (EM-tunnel) is embedded, have been proposed in Korean Patent Application No. 10-2016-0006066, U.S. Patent Application No. US 15043288, Chinese Patent Application No. CN 2016100854078, and the like. The existing EM-tunnel-embedded PCB has a structure of EM-tunnel that includes a vertical EM-tunnel to be connected a horizontal EM-tunnel. Also the structure of the existing EM-tunnel-embedded PCB requires components for microstrip-to-waveguide transition (hereinafter, referred to as an MWT) involving a function of a transmitting antenna or a receiving antenna and the components of the transmitting antenna or the receiving antenna are placed on a surface of the PCB.

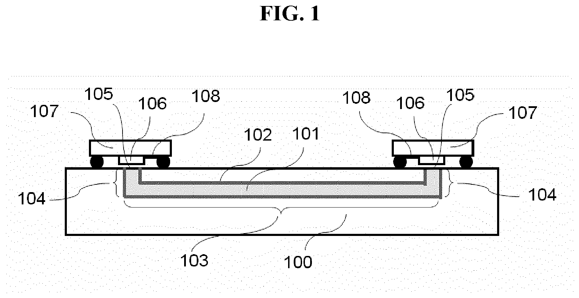

For example, with reference to FIG. 1 illustrating a structure of an existing PCB, in which an EM-tunnel is embedded, EM-tunnels 103 and 104, each of which includes a dielectric core 101 and a metal clad 102 that surrounds the dielectric core 101, are embedded in the PCB 100, and the input/output ports 105 of the EM tunnel 103 and 104 may be exposed to an upper surface of the PCB 100. Accordingly, data transmitting/receiving chips 107 and MWTs 106 formed on bottom side thereof are placed on a surface of the PCB 100 to contact the input/output ports 105 of the EM-tunnels 103 and 104.

Then, because each of the EM-tunnels 103 and 104 includes a horizontal part 103 and a vertical part 104, the propagation directions of the electromagnetic signals are abruptly changed in the junction region where the horizontal parts 103 and the vertical parts 104 are connected to each other. Accordingly, in the junction region of the EM-tunnels, where the horizontal parts 103 and the vertical parts 104 are connected to each other, some loss of electromagnetic wave could be generated by the scattering and reflection in the junction region of the vertical and horizontal parts, resulting in disturbances of signals.

Accordingly, a technology of solving the problems of the EM-tunnel in the existing PCB is required.

Embodiments of the inventive concept provides a PCB in which electromagnetic signal transmitting (hereinafter, referred to as a Tx) antennas and electromagnetic signal receiving (hereinafter, referred to as a Rx) antennas of electromagnetic wave are embedded with an EM-tunnel having only a horizontal part to solve the above-mentioned problems.

### SUMMARY

Embodiments provide a printed circuit board (PCB), in which electromagnetic signal Tx and Rx antennas are embedded therein such that an EM-tunnel is formed only horizontally, so that the problems of scattering loss of electromagnetic signals and distortion of signals in the EM-tunnel may be solved or reduced by simplifying the structure of the EM-tunnel.

Embodiments also provide a technology of determining configurations of Tx and Rx antennas embedded in a PCB, depending on the directions of radiation and impinging of electromagnetic signals from/to the Tx and Rx antennas.

Embodiments also provide a technology of a PCB that includes a plurality of sets of Tx antennas and Rx antennas such that the plurality of sets of Tx antennas and Rx antennas may transmit and receive electromagnetic signals of multiple channels through a single EM-tunnel.

In accordance with an aspect of the inventive concept, there is provided a PCB structure, in which a Tx antenna and a Rx antenna, and an EM-tunnel are embedded; with an feature of EM-tunnel that consist of a dielectric core and a metal clad and is aligned parallel to the PCB and with an feature of Tx antenna and Rx antenna that is respectively configured at an input port and an output port of the EM-tunnel embedded in the PCB to transmit and receive electromagnetic signals through the EM-tunnel.

The Tx and Rx antennas may have planar shapes, and configuration of the Tx and Rx antennas in the PCB may be determined based on directions of the electromagnetic signals transmitted from the Tx antenna and received to the Rx antenna.

The plurality of sets of Tx antennas and Rx antennas may be embedded with multilayered structures in the PCB and may be placed at the input port and the output port of a single EM-tunnel.

The Tx antenna and the Rx antenna may be connected to a component of microstrip-to-waveguide transition (MWT) that is placed on a surface of the PCB or is placed in the PCB.

Any one of the input port and the output of the EM-tunnel may be exposed to a surface of the PCB and may be coupled to a connector that connects the EM-tunnel to an electromagnetic tube (E-tube) provided outside the PCB.

In accordance with another aspect of the inventive concept, there is provided a method for manufacturing a PCB structure, in which a Tx antenna, a Rx antenna and an EM-tunnel are embedded. The method including embedding an EM-tunnel including a dielectric core and a metal clad that surrounds the dielectric core in the PCB, the EM-tunnel being parallel to the PCB, and embedding the Tx antenna and the Rx antenna in the PCB, wherein the embedding of the Tx antenna and the Rx antenna includes arranging the Tx antenna and the Rx antenna at an input port and an output port of the EM-tunnel.

### BRIEF DESCRIPTION OF THE FIGURES

The above and other objects and features will become apparent from the following description with reference to the following figures, wherein like reference numerals refer to like parts throughout the various figures unless otherwise specified, and wherein:
FIG. 1 is a cross-sectional view illustrating a structure of a PCB, in which an EM-tunnel is embedded, according to the related art;
FIGS. 2A and 2B are views illustrating a structure of a PCB in which a Tx antenna and a Rx antenna, and an EM-tunnel are embedded;
FIGS. 3A and 3B are views illustrating a structure of a PCB having a plurality of sets of Tx antennas and Rx antennas;
FIG. 4 is a cross-sectional view illustrating a structure of a PCB including a Tx antenna and a Rx antenna, of which transmitting and receiving directions of electromagnetic signals are horizontal according to an embodiment;
FIG. 5 is a cross-sectional view illustrating a structure of a PCB including a Tx antenna and a Rx antenna, of which transmitting and receiving directions of electromagnetic signals are vertical according to an embodiment;
FIG. 6 is a cross-sectional view illustrating a structure of a PCB including a Tx antenna and a Rx antenna, of which transmitting and receiving directions of electromagnetic signals are inclined at a specific angle according to an embodiment;
FIGS. 7A and 7B are views illustrating a structure in which a PCB, in which a Tx or Rx antenna and an EM-tunnel are embedded, is connected to an E-tube provided outside the PCB according to an embodiment; and
FIG. 8 is a flowchart illustrating a method of manufacturing a PCB having the Tx antenna and the Rx antenna and the EM-channel according to an embodiment.

### DETAILED DESCRIPTION

Hereinafter, exemplary embodiments of the inventive concept will be described in detail with reference to the accompanying drawings. However, the inventive concept is neither limited nor restricted by the embodiments. Further, the same reference numerals in the drawings denote the same members.

Furthermore, the terminologies used herein are used to properly express the embodiments of the inventive concept, and may be changed according to the intentions of the user or the manager or the custom in the field to which the inventive concept pertains. Therefore, definition of the terms should be made according to the overall disclosure set forth herein.

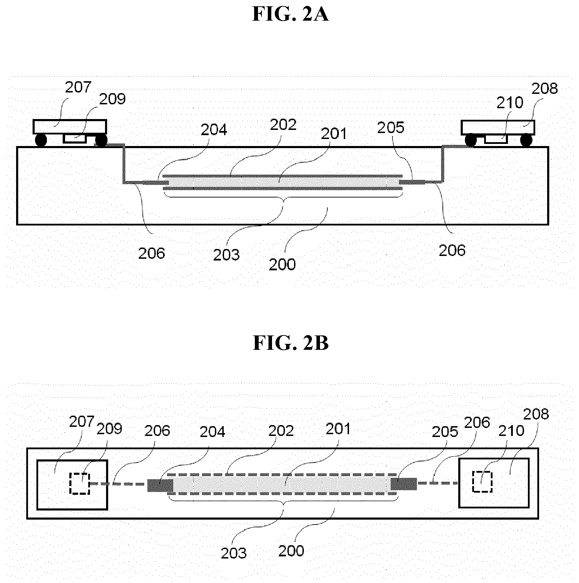

FIGS. 2A and 2B are views illustrating a structure of a PCB, in which a Tx antenna and a Rx antenna, and an EM-tunnel are embedded. In detail, FIG. 2A is a cross-sectional view and FIG. 2B is a plan view, illustrating a structure of a PCB, in which a Tx antenna and a Rx antenna, and an EM-tunnel are embedded.

Referring to FIGS. 2A and 2B, the PCB 200 according to an embodiment includes an EM-tunnel 203 that consists of a dielectric core 201 and a metal clad 202 surrounding the dielectric core 201 and is aligned parallel to the PCB 200. Accordingly, an input port and an output port of the EM-tunnel 203 are also embedded in the PCB 200. Hereinafter, because air is also a dielectric material in a wide meaning, it will be described that the dielectric core 201 includes a core of an empty space. That is, a rectangular peripheral area of the cross-section of the EM-tunnel may correspond to the metal clad 202, and the inside of the EM-tunnel may correspond to the dielectric core 201.

Here, the EM-tunnel 203 may transfer an electromagnetic signal of an appropriate frequency band in which absorption of the electromagnetic signal by the metal clad 202 may be enough small. Further, because the EM-tunnel 203 has to be embedded in the PCB 200, the thickness (height in vertical direction) of the EM-tunnel 203 may be adjusted based on the frequency band of the electromagnetic signal and the thickness of the PCB 200. Further, the cross-sectional shape of the EM-tunnel 203 may have any one of a triangular shape, a rectangular shape, a polygonal shape, or a circular shape.

A Tx antenna and a Rx antenna 204 and 205 that transmits and receives electromagnetic signals are embedded in the PCB 200. Here, the Tx antenna and the Rx antenna 204 and 205 may be placed at the input port and the output port of the EM-tunnel 203 to transmit and receive electromagnetic signals through the EM-tunnel 203.

For example, the Tx antenna 204 is embedded in the PCB 200 such that a portion thereof may be inserted into the input port of the EM-tunnel 203, to transmit an electromagnetic signal to the inside of the EM-tunnel 203, and the Rx antenna 205 may be embedded in the PCB 200 such that a portion thereof may be inserted into the output port of the EM-tunnel 203, to receive an electromagnetic signal through the EM-tunnel. However, the inventive concept is not limited thereto, but the Tx antenna 204 may be arranged at a location that is close to the input port of the EM-tunnel such that an electromagnetic signal may be transmitted to the inside of the EM-tunnel 203, and the Rx antenna 205 may be arranged at a location that is close to the output port of the EM-tunnel 203 such that an electromagnetic signal may be received from the inside of the EM-tunnel 203.

The Tx antenna and the Rx antenna 204 and 205 may be connected through metal lines or microstrip lines 206 to the components of MWT 209 and 210 which are integrated in a data transmitting chip and a data receiving chip 207 and 208, respectively. The MWT provides functions of signal conversion between electrical signals and electromagnetic signals. MWT 209 in the transmitting part converts electrical signals that is supplied from the transmitting chip 207 to an electromagnetic signal. MWT 210 in the receiving part converts electromagnetic signals to electrical signals that is supplied to the receiving chip 208. Accordingly, the Tx antenna 204 may receive an electromagnetic signal from a MWT 209 in the data transmitting chip 207 through the metal line or the microstrip line 206. The Rx antenna 205 may receiver an electromagnetic signal from the EM-tunnel and transfer the electromagnetic signal through the metal line or the microstrip line 206 to a MWT 210 in the data receiving chip 208.

Although it is illustrated in the drawings that the data transmitting chip and the data receiving chip 207 and 208 and the MWTs 209 and 210 are placed on a surface of the PCB 200, the inventive concept is neither restricted nor limited thereto and the data transmitting/receiving chips 207 and 208 and the MWTs 209 and 210 may be placed in the PCB 200.

The Tx antenna and the Rx antenna 204 and 205 may have planar shapes to be embedded in the PCB 200. However, the inventive concept is neither restricted nor limited thereto, and the Tx antenna and the Rx antenna 204 and 205 may have various forms by which they may be embedded in the PCB 200. In this case, the forms of the Tx antenna and the Rx antenna 204 and 205 may be determined based on the frequency of the electromagnetic wave and the thickness of the PCB 200.

The Tx antenna and the Rx antenna 204 and 205 having planar shapes may have various transmitting and receiving directions of electromagnetic signals with respect to the surfaces of the Rx antenna and the Rx antenna 204 and 205. For example, the Tx antenna and the Rx antenna 204 and 205 may have transmitting and receiving directions of electromagnetic signals that are parallel, perpendicular, or inclined at specific angles with respect to the surfaces of the Tx antenna and the Rx antenna 204 and 205.

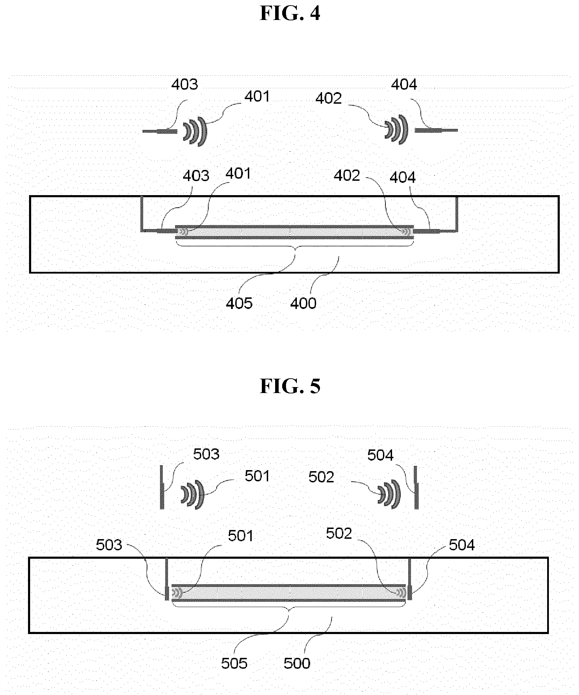

The configurations of the Tx antenna and the Rx antenna 204 and 205, at which they are arranged at the input port and the output port of the EM-tunnel 203, may be differently determined depending on the direction of transmitting and receiving electromagnetic signals. A detailed description thereof will be made with reference to FIGS. 4 to 6.

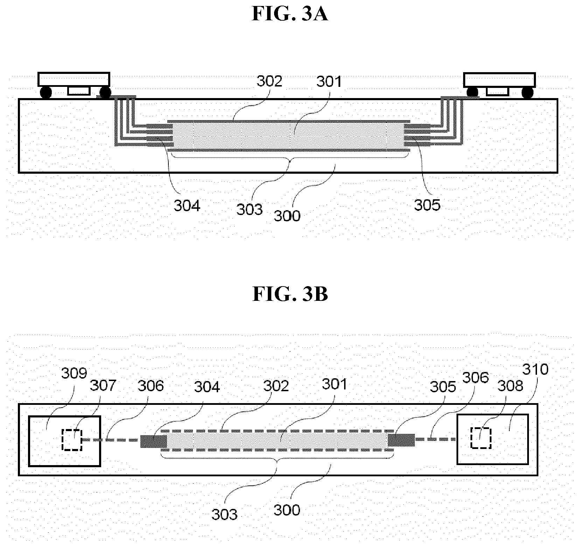

Further, a plurality of sets of Tx antennas and Rx antennas 204 and 205 may be provided. A detailed description thereof will be made with reference to FIGS. 3A and 3B.

FIGS. 3A and 3B are views illustrating a structure of a PCB having a plurality of sets of Tx antennas and Rx antennas. In detail, FIG. 3A is a cross-sectional view and FIG. 3B is a plan view, illustrating a structure of a PCB including a plurality of sets of Tx antennas and Rx antennas.

Referring to FIGS. 3A and 3B, like the PCB described with reference to FIGS. 2A and 2B, the PCB 300 according to an embodiment includes a dielectric core 301 and a metal clad 302 that surrounds the dielectric core 301, and an EM-tunnel 303 that is parallel to the PCB 300 is embedded in the PCB 300.

However, unlike in the PCB described with reference to FIGS. 2A and 2B, a plurality of sets of Tx antennas and Rx antennas 304 and 305 are embedded in the PCB 300 according to an embodiment. Here, the plurality of sets of Tx antennas and Rx antennas 304 and 305 are arranged at the input port and the output port of one EM-tunnel 303, and may transmit and receive electromagnetic signals of multiple channels through a single EM-tunnel 303.

Here, the electromagnetic signals of multiple channels, which are transmitted and received by the plurality of sets of Tx antennas and Rx antennas 304 and 305, may be electromagnetic signals of different frequency bands. For example, a first set of a Tx and a Rx antenna may be arranged at the input and output port of the EM-tunnel 303 such they correspond to each other, to transmit and receive an electromagnetic signal of a first channel to and from the inside of the EM-tunnel 303, and a second set of a Tx and a Rx antenna may be arranged at the input and output port of the EM-tunnel 303 such that they correspond to each other, to transmit and receive an electromagnetic signal of a second channel to and from the inside of the EM-tunnel 303.

Then, the plurality of sets of Tx antennas and Rx antennas 304 and 305 may be arranged with a multilayered structure at the input and output port of the EM-tunnel 303 in the interior of the PCB 300.

FIG. 4 is a cross-sectional view illustrating a structure of a PCB including a Tx antenna and a Rx antenna, of which directions of transmitting and receiving electromagnetic signals are parallel to each other according to an embodiment. Hereinafter, it will be described that the PCB 400 according to an embodiment has a simple structure including only an EM-tunnel 405 and the Tx antenna and the Rx antenna 403 and 404 to explain configurations of the Tx antenna and the Rx antenna 403 and 404 based on the directions of transmitting and receiving electromagnetic signals 401 and 402. Further, the directions of transmitting and receiving electromagnetic signals means directions that have the highest electromagnetic signal strengths in distributions of electromagnetic waves that are widely radiated or impinged with a solid angle from and to the antennas, and will be referred to as transmitting and receiving directions hereinafter.

Referring to FIG. 4, the configurations of the Tx antenna and the Rx antenna 403 and 404, at which they are arranged at the input port and the output port of the EM-tunnel 403, may be determined based on the transmitting and receiving directions 401 and 402.

As illustrated in the drawing, when the transmitting and receiving directions 401 and 402 of the Tx antenna and the Rx antenna 403 and 404 are parallel to the surfaces of the Tx antenna and the Rx antenna 403 and 404 (when the transmitting and receiving directions 401 and 402 are parallel to the directions in which the planar Tx antenna and Rx antenna 403 and 404 are aligned), the Tx antenna and the Rx antenna 403 and 404 may be configured parallel to the PCB 400 such that electromagnetic signals are transmitted and received to and from the EM-tunnel 405.

Then, the Tx antenna and the Rx antenna 403 and 404 may be arranged such that ends thereof are close to the input port and the output port of the EM-tunnel 405 so that electromagnetic signals are transmitted and received to and from the inside of the EM-tunnel 405.

FIG. 5 is a cross-sectional view illustrating a structure of a PCB including a Tx antenna and a Rx antenna, of which directions of transmitting and receiving electromagnetic signals are vertical according to an embodiment. Hereinafter, it will be described that the PCB 500 according to an embodiment has a simple structure including only an EM-tunnel 505 and the Tx antenna and the Rx antenna 503 and 504 to explain configurations of the Tx antenna and the Rx antenna 503 and 504 based on the transmitting and receiving directions 501 and 502.

Referring to FIG. 5, the configurations of the Tx antenna and the Rx antenna 503 and 504, at which they are arranged at the input port and the output port of the EM-tunnel 505, may be determined based on the electromagnetic signal transmission and reception directions 501 and 502.

As illustrated in the drawing, when the transmitting and receiving directions 501 and 502 of the Tx antenna and the Rx antenna 503 and 504 are perpendicular to the surfaces of the Tx antenna and the Rx antenna 503 and 504 (when the transmitting and receiving directions 501 and 502 are perpendicular to the directions in which the planar Tx antenna and Rx antenna 503 and 504 are aligned), the Tx antenna and the Rx antenna 503 and 504 may be configured perpendicular to the PCB 500 such that electromagnetic signals are transmitted and received to and from the EM-tunnel 505.

Then, the Tx antenna and the Rx antenna 503 and 504 may be arranged such that surfaces thereof are close to the input port and the output port of the EM-tunnel 505 so that electromagnetic signals are transmitted and received to and from the inside of the EM-tunnel 505.

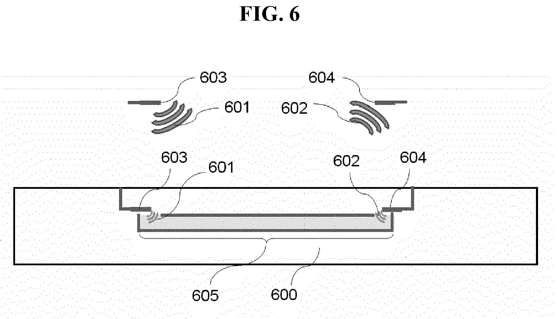

FIG. 6 is a cross-sectional view illustrating a structure of a PCB including a Tx antenna and a Rx antenna, of which directions of transmitting and receiving electromagnetic signals are inclined at a specific angle according to an embodiment. Hereinafter, it will be described that the PCB 600 according to an embodiment has a simple structure including only an EM-tunnel 605 and the Tx antenna and the Rx antenna 603 and 604 to explain locations of the Tx antenna and the Rx antenna 603 and 604 based on the transmitting and receiving directions 601 and 602.

Referring to FIG. 6, the configurations of the Tx antenna and the Rx antenna 603 and 604, at which they are arranged at the input port and the output port of the EM-tunnel 605, may be determined based on the transmitting and receiving directions 601 and 602.

As illustrated in the drawing, when the transmitting and receiving directions 601 and 602 of the Tx antenna and the Rx antenna 603 and 604 are inclined at a specific angle with respect to the surfaces of the Tx antenna and the Rx antenna 603 and 604 (when the transmitting and receiving directions 601 and 602 are inclined at a specific angle with respect to the directions in which the Tx antenna and the Rx antenna 603 and 604 are aligned), the Tx antenna and the Rx antenna 603 and 604 may be configured parallel to the PCB 600 covering some open area of the input port and the output port formed on upper or lower side of the EM-tunnel 605 so that electromagnetic signals are transmitted and received to and from the EM-tunnel 605.

When the input port and the output port of the EM-tunnel 605 are formed on an upper surface or a lower surface of the EM-tunnel 605, vertical metal clads may be formed at the ends of the EM-tunnel so that electromagnetic waves can be confined inside the EM-tunnel 605. In this case, the metal clads formed at the ends of the EM-tunnel 605 may have an inclined or curved shape instead of a vertical shape so that loss of electromagnetic signals may be minimized at vertical portions thereof.

As described with reference to FIGS. 4 to 6, the Tx antenna and the Rx antenna according to embodiments are appropriately configured at the input port and the output port of the EM-tunnel, based on the transmitting and receiving directions of antennas, so that the PCB having the Tx antenna and the Rx antenna and the EM-tunnel may achieve an effective transmitting/receiving function of electromagnetic signals.

Further, the configuration of the Tx antenna and the Rx antenna based on the transmitting and receiving directions of antennas, as described above, may be also applied to the case in which a plurality of sets of Tx antennas and Rx antennas.

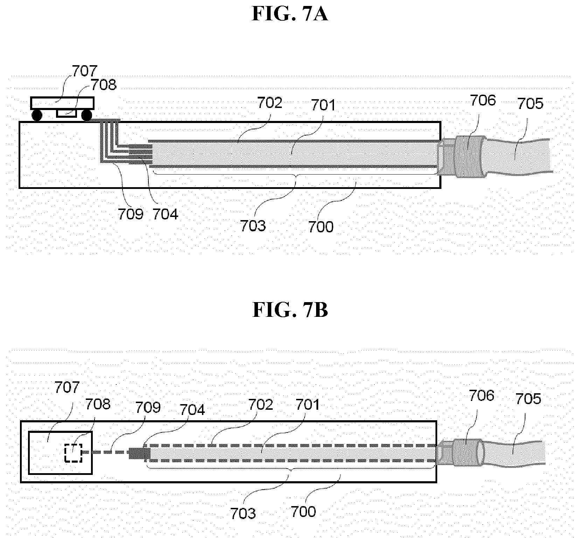

FIGS. 7A and 7B are views illustrating a structure of a PCB embedding a Tx antenna or a Rx antenna and an EM-tunnel, which is connected to an E-tube provided outside the PCB according to an embodiment. In detail, FIG. 7A is a sectional view and Fig. 7B is a plane view of the embodied PCB of which EM-tunnel is connected to the electromagnetic tube (E-tube).

Referring to FIGS. 7A and 7B, like the PCB described with reference to FIGS. 2A and 2B, the PCB 700 according to an embodiment includes a dielectric core 701 and a metal clad 702 that surrounds the dielectric core 701, and an EM-tunnel 703 that is parallel to the PCB 700 is embedded in the PCB 700.

Further, a Tx antenna (or a Rx antenna) 704 is embedded in the PCB 700. Meanwhile, unlike the PCB described with reference to FIGS. 2A and 2B, the PCB 700 according to an embodiment is configured such that any one of the input port and the output port of the EM-tunnel 703 is exposed to a surface (in particular, a side surface) of the PCB 700 to be coupled to a connector 706 that connects the EM-tunnel 703 to an E-tube provided from outside the PCB 700.

For example, the Tx antenna 704 embedded in the PCB 700 may transmit an electromagnetic signal which is converted from an electrical signal by a MWT 708 integrated in a data transmitting chip 707 through a metal line or a microstrip line 709, and may transfer electromagnetic signals to the E-tube 705 through the EM-tunnel 703.

As another example, the Rx antenna 704 embedded in the PCB 700 may receive an electromagnetic signal which is transferred from E-tube 705 and the EM-tunnel 703 through the metal line or the microstrip line 709, and then a MWT 708 mounted on a data receiving chip 707 converts the electromagnetic into an electrical signal.

Here, the connector 706 is a coupling component that connects two electromagnetic waveguides of the EM-tunnel 703 and the E-tube 705, having different cross-sectional shapes each other. One connecting part of the connector 706 may have a cross-sectional shape corresponding to the cross-sectional shape of the EM-tunnel 703 and the other connecting part of the connector 706 may have a cross-sectional shape corresponding to the cross-sectional shape of the E-tube 705. However, the inventive concept is neither restricted nor limited thereto, and as the cross-sectional shapes of the EM-tunnel 703 and the E-tube 705 may have various forms, the shapes of the connecting parts of the connector 706 may be also appropriately adjusted. For example, when the Tx antenna or the Rx antenna is inclined at a specific angle as in FIG. 6 and the input port or the output port of the EM-tunnel 703 faces an upper or lower surface of the PCB 700, the connector 705 for connection with the E-tube 705 may have a shape that is suitable for connection through an upper or lower surface of the PCB 700.

Although it is illustrated in the drawing that a plurality of Tx antennas (or a plurality of receiving antennas) 704 are embedded in the PCB 700, one Tx antenna (or one Rx antenna) may be embedded in the PCB 700.

As illustrated in the drawings, when a plurality of Tx antennas 704 are embedded, electromagnetic signals of multiple channels may be transmitted (or received) through a single E-tube with a single connector, and such connecting structures can simplify a data transmission system requiring multiple data channels.

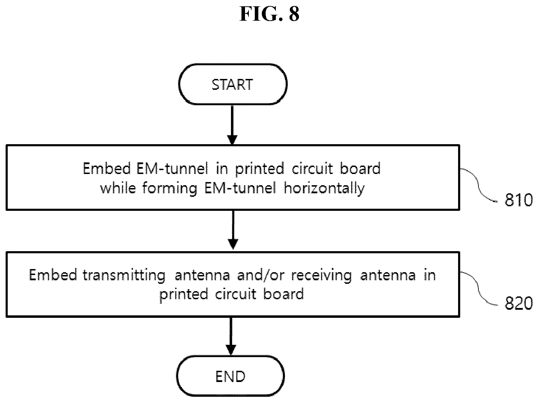

FIG. 8 is a flowchart illustrating a method of manufacturing a PCB embedding a Tx antenna and a Rx antenna and an EM-channel according to an embodiment.

Referring to FIG. 8, a system for manufacturing a PCB (hereinafter, referred to as the system) according to an embodiment embeds an EM-tunnel including a dielectric core and a metal clad that surrounds the dielectric core in the PCB while forming the EM-tunnel in parallel to the PCB (810).

Then, in operation 810, the system may form the EM-channel such that the input port and the output port of the EM-tunnel are also embedded in the PCB.

However, the inventive concept is neither restricted nor limited thereto, and the system may expose any one of the input port and the output port of the EM-tunnel to a surface of the PCB such that the any one of the input port and the output port of the EM-tunnel is coupled to a connector that connects the any one of the input port and the output port of the EM-tunnel to an E-tube provided outside the PCB. In this case, in operation 820, the system may embed a Tx antenna or a Rx antenna of an electromagnetic wave in the PCB.

Thereafter, the system embeds a Tx antenna and a Rx antenna in the PCB (820). In detail, the system may arrange the locations of the Tx antenna and the Rx antenna at the input port and the output port of the EM tunnel such that electromagnetic signals may be transmitted and received to and from the EM-tunnel.

Then, the system forms the Tx antenna and the Rx antenna which have planar shapes, and the configurations of the Tx antenna and the Rx antenna, at which they are arranged to the input port and the output port of the EM-tunnel may be determined based on the transmitting and receiving directions of the Tx antenna and the Rx antenna with respect to surfaces of the Tx antenna and the Rx antenna.

For example, when the transmitting and receiving directions of the Tx antenna and the Rx antenna are parallel to the surfaces of the Tx antenna and the Rx antenna, the system may arrange the Tx antenna and the Rx antenna in parallel to the PCB such that electromagnetic signals are transmitted and received to and from the inside of the EM-tunnel.

As another example, when the transmitting and receiving directions of the Tx antenna and the Rx antenna are perpendicular to the surfaces of the Tx antenna and the Rx antenna, the system may arrange the Tx antenna and the Rx antenna which are perpendicular to the PCB such that electromagnetic signals are transmitted and received to and from the inside of the EM-tunnel.

As another example, when the transmitting and receiving directions of the Tx antenna and the Rx antenna are inclined with respect to the surfaces of the Tx antenna and the Rx antenna, the system may arrange the Tx antenna and the Rx antenna covering some open area of the input port and the output port formed on upper or lower side of the EM-tunnel such that electromagnetic signals are transmitted and received to and from the inside of the EM-tunnel. output port

In operation 820, the system may embed a plurality of sets of Tx antennas and Rx antennas in the PCB. In this case, the system may arrange the plurality of sets of Tx antennas and Rx antennas with a multilayered structure at the input port and the output port of the EM-tunnel.

Operation 810 of embedding an EM-tunnel and operation 820 of embedding antennas that have been described with reference to FIG. 8 have been simply classified into two steps of the process of manufacturing a PCB according to the inventive concept is classified into two steps, and the steps may be combined or reversed in the detailed manufacturing process. Like a conventional PCB manufacturing process, circuit patterns formed with the multilayered thin films may be combined when the printed thin films are laminated, and two-step processes may be combined or reversed in the detailed process of sequential lamination of the thin films.

Further, although FIGS. 2 to 8 illustrates a form in which an Tx antenna and an Rx antenna are buried in the PCB, grooves are formed close to the input port and the output port of the EM-tunnel and the Tx antenna and the Rx antenna are inserted into the grooves, and the insertion form belongs to the embedding form of the inventive concept.

Furthermore, although embodiments described with reference to FIGS. 2 to 6 and 8 involve both transmitting-side components (transmitting antenna, input port of EM-tunnel, transmitting chip etc) and receiving-side components (receiving antenna, output port of EM-tunnel, receiving chip etc), the inventive purpose can be achieved in the case that only either side components are employed in the PCB and such cases are also belong to the inventive concept.

According to an embodiment, a deflection of electromagnetic wave may be excluded or restrained by embedding the horizontal EM-tunnel with the Tx and Rx antennas which are placed close to the input and out ports of the EM-tunnel, so that scattering loss and signal distortion due to the deflection of the electromagnetic wave to be induced at any deflected region of a EM-tunnel may be solved or restrained.

Accordingly, an embodiment may provide a technology of determining configurations of the Tx and Rx antennas which are embedded in the PCB based on the transmitting and receiving directions of electromagnetic signals of the Tx and Rx antennas.

Further, embodiments may also provide a technology of a PCB that includes a plurality of sets of Tx antennas and Rx antennas such that the plurality of sets of Tx antennas and Rx antennas may transmit and receive electromagnetic signals of multiple channels to and from a single EM-tunnel.

Although the embodiments of the present disclosure have been described with reference to the limited embodiments and the drawings, the inventive concept may be variously corrected and modified from the above description by those skilled in the art to which the inventive concept pertains. For example, the above-described technologies can achieve a suitable result even though they are performed in different sequences from those of the above-mentioned method and/or coupled or combined in different forms from the method in which the constituent elements such as the system, the architecture, the device, or the circuit are described, or replaced or substituted by other constituent elements or equivalents.

Therefore, the other implementations, other embodiments, and the equivalents of the claims pertain to the scope of the claims.

## Claims

1. A printed circuit board (PCB) structure, in which an electromagnetic signal transmitting antenna and/or an electromagnetic signal receiving antenna, and an electromagnetic signal transferring tunnel (EM-tunnel) are embedded, the printed circuit board structure comprising:
a printed circuit board;
an EM-tunnel that comprises a dielectric core and a metal clad that surrounds the dielectric core and that is embedded in the printed circuit board to be parallel to the printed circuit board; and
at least one transmitting antenna and/or at least one receiving antenna that are embedded in the printed circuit board,
wherein the transmitting antenna and/or the receiving antenna are arranged at an input port and an output port of the EM-tunnel embedded in the printed circuit board to transmit and receive electromagnetic signals to and from the inside of the EM-tunnel.

2. The printed circuit board structure of claim 1, wherein the transmitting antenna and/or the receiving antenna have planar shapes, and configurations of the transmitting antenna and/or the receiving antenna, at which the transmitting antenna and/or the receiving antenna are arranged at the input port and the output port of the EM-tunnel, are determined based on the transmitting and receiving directions of electromagnetic signals from the transmitting antenna and to receiving antenna.

3. The printed circuit board structure of claim 2, wherein the transmitting antenna and/or the receiving antenna are configured to be parallel the printed circuit board such that the electromagnetic signals are transmitted and received to and from the inside of the EM-tunnel when the transmitting and receiving directions of electromagnetic signals are parallel to surfaces of the transmitting antenna and/or the receiving antenna.

4. The printed circuit board structure of claim 2, wherein the transmitting antenna and/or the receiving antenna are configured to be perpendicular to the printed circuit board such that the electromagnetic signals are transmitted and received to and from the inside of the EM-tunnel when the transmitting and receiving directions of electromagnetic signals are perpendicular to surfaces of the transmitting antenna and/or the receiving antenna.

5. The printed circuit board structure of claim 2, wherein the transmitting antenna and/or the receiving antenna are configured to be parallel to the printed circuit board so as covering some open area of the input port and the output port formed on upper or lower side of the EM-tunnel such that the electromagnetic signals are transmitted and received to and from the inside of the EM-tunnel when the transmitting and receiving directions of electromagnetic signals are inclined at a specific angle with respect to surfaces of the transmitting antenna and/or the receiving antenna.

6. The printed circuit board structure of claim 1, wherein the transmitting antenna and/or the receiving antenna comprise a plurality of sets of transmitting antennas and receiving antennas, and
wherein the plurality of sets of transmitting antennas and receiving antennas transmit and receive electromagnetic signals of multiple channels to and from the EM-tunnel.

7. The printed circuit board structure of claim 6, wherein the plurality of sets of transmitting antennas and receiving antennas are embedded with multilayered structures, respectively, in the printed circuit board and are configured at the input port and the output port of a single EM-tunnel.

8. The printed circuit board structure of claim 1, wherein any one of the input port and the output port of the EM-tunnel is exposed to a surface of the printed circuit board and is coupled to a connector that connects the EM-tunnel to an electromagnetic signal transferring tube (E-tube) provided outside the printed circuit board.

9. The printed circuit board structure of claim 1, wherein the transmitting antenna and/or the receiving antenna are connected to a component of microstrip-to-waveguide transition that is placed on a surface of the printed circuit board or in the printed circuit board.

10. A method for manufacturing a printed circuit board (PCB) structure, in which an electromagnetic signal transmitting antenna and/or an electromagnetic signal receiving antenna, and an electromagnetic signal transferring tunnel (EM-tunnel) are embedded, the method comprising:
embedding an EM-tunnel comprising a dielectric core and a metal clad that surrounds the dielectric core in the printed circuit board, the EM-tunnel being parallel to the printed circuit board; and
embedding the transmitting antenna and/or the receiving antenna in the printed circuit board,
wherein the embedding of the transmitting antenna and/or the receiving antenna comprises:
configuring the transmitting antenna and/or the receiving antenna at an input port and an output port of the EM-tunnel such that electromagnetic signals are transmitted and received to and from the inside of the EM-tunnel.
